# FASCICULE DE BREVET EUROPEEN

(11) **EP 2 587 668 B1**
(45) Date de publication et mention de la délivrance du brevet: **13.05.2015**
(21) Numéro de dépôt: 12189666.6
(22) Date de dépôt: 24.10.2012
(51) Int. Cl.: H03H 9/74, H03H 9/76

(54) **Combineur de puissance à ondes acoustiques**
Leistungskoppler verwendend akustische Wellen
Power combiner using acoustic waves

(30) Priorité: 28.10.2011 FR 1159816
(43) Date de publication de la demande: 01.05.2013
(73) Titulaire: COMMISSARIAT A L'ENERGIE ATOMIQUE ET AUX ENERGIES ALTERNATIVES, 75015 Paris (FR)
(72) Inventeur: Reinhardt, Alexandre, 38400 SAINT MARTIN D'HERES (FR)
(74) Mandataire: Esselin, Sophie

(56) Documents cités:
- EP-A1- 2 385 625
- GB-A- 1 386 243
- JP-A- 60 160 719
- US-A- 4 590 442
- US-B1- 6 683 515

## Description

Le domaine de l'invention est celui des dispositifs électromécaniques exploitant la propagation d'ondes acoustiques en lieu et place de signaux électriques en vue de réaliser une fonction de combineur de puissance, notamment RF, tout en conservant une isolation élevée entre les ports d'accès.

Les composants appelés « combineurs » sont utilisés dans des systèmes radiofréquence pour combiner la puissance de deux signaux. Par exemple, les architectures d'amplificateurs évoluées nécessitent ce type de dispositif afin de combiner les signaux amplifiés provenant de multiples branches. Ce principe est notamment utilisé pour réaliser des amplificateurs linéaires à partir d'amplificateurs fonctionnant en régime non-linéaire (LINC) et se trouvant par cela d'une meilleure efficacité énergétique.

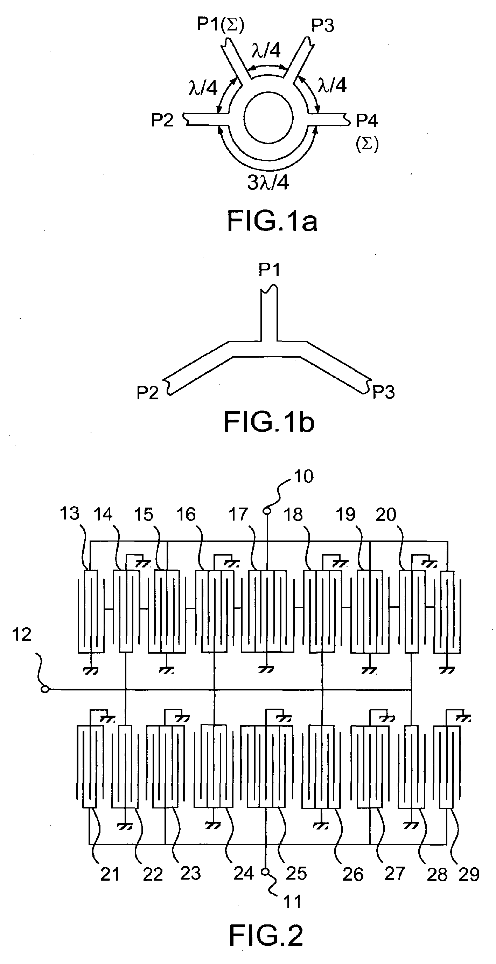

De manière générale, un combineur est un dispositif permettant d'effectuer la combinaison de deux signaux (ou plus) en un seul signal. Selon l'architecture du combineur, il est désirable d'ajouter en plus une isolation entre les ports d'entrée, afin de limiter l'influence de chaque branche du circuit sur les autres. Les combineurs conventionnels sont réalisés à partir d'éléments passifs discrets ou de lignes de transmission, comme illustré en figures 1a et 1b qui montrent des combineurs ou diviseurs de puissance réalisés sous forme de lignes de transmission avec isolation des ports d'entrée et sans isolation particulière.

Dans le contexte des télécommunications sans fil mobiles, telles que la téléphonie mobile, les dimensions des circuits doivent être miniaturisées. Toutefois, les solutions traditionnelles occupent un espace encombrant et sont difficilement miniaturisables. Par exemple, la solution utilisant des composants passifs discrets (inductances, capacités) nécessite des éléments de fortes valeurs difficiles à intégrer et présentant de fortes pertes. Par ailleurs, les solutions utilisant des lignes de transmission micro-ondes nécessitent de longues lignes, car dépendant des longueurs d'ondes électriques qui sont typiquement de l'ordre du centimètre à des fréquences inférieures à quelques GHz. Il existe donc un besoin important de trouver des solutions intégrables, c'est-à-dire miniaturisables, afin de permettre la réalisation de nombreuses architectures nécessitant des combinaisons de puissance, en particulier RF, pour les applications de type téléphonie mobile et systèmes sans fil portables.

Dans ce contexte, plusieurs solutions ont déjà été proposées. Ces solutions ont en commun l'exploitation d'ondes acoustiques pour réaliser des fonctions de combineur ou de séparateur. Ces ondes acoustiques présentent des longueurs d'onde bien plus courtes que les longueurs d'onde électriques (de l'ordre du µm à des fréquences inférieures à quelques GHz), et permettent donc une miniaturisation poussée.

Une première solution décrite dans le brevet japonais JP 60160719 « *Surface acoustic wave power splitter* », 1985, propose de réaliser un diviseur de puissance (*power splitter* en anglais) en utilisant des transducteurs à ondes acoustiques de surface disposés symétriquement selon deux chemins distincts. La structure proposée est composé d'une série de transducteurs à peignes interdigités, disposés sur deux chemins acoustiques comme représenté en figure 2, et reliés à un port d'entrée et permettant de convertir le signal électrique en ondes acoustiques de surface. Ces ondes se propagent ensuite jusqu'à d'autres transducteurs reliés aux ports de sortie et permettent donc d'y amener le signal électrique. La symétrie permet d'assurer qu'une même puissance est transmise aux deux sorties. Par contre, en vue d'une utilisation en tant que combineur, cette disposition n'assure pas spécifiquement une isolation entre les ports 10 et 11 : un signal reçu par exemple par le port 10 est transmis au port 12 qui peut à son tour réémettre des ondes sur le chemin acoustique inférieur et le transmettre au port 11.

Il est par aileurs connu du Document GB 1 386 243, un dispositif à ondes élastiques comprenant au moins une première voie acoustique et une seconde voie acoutique, chaque voie comportant un premier transducteur, un second transducteur et un transducteur intercalaire de couplage flottant commun aux voies et permettant de transférer de l'énergie d'une voie à l'autre. Il est prévu des moyens d'isolation en dédoublant le transducteur flottant en deux transducteurs flottants séparés d'une distance de λ/2.

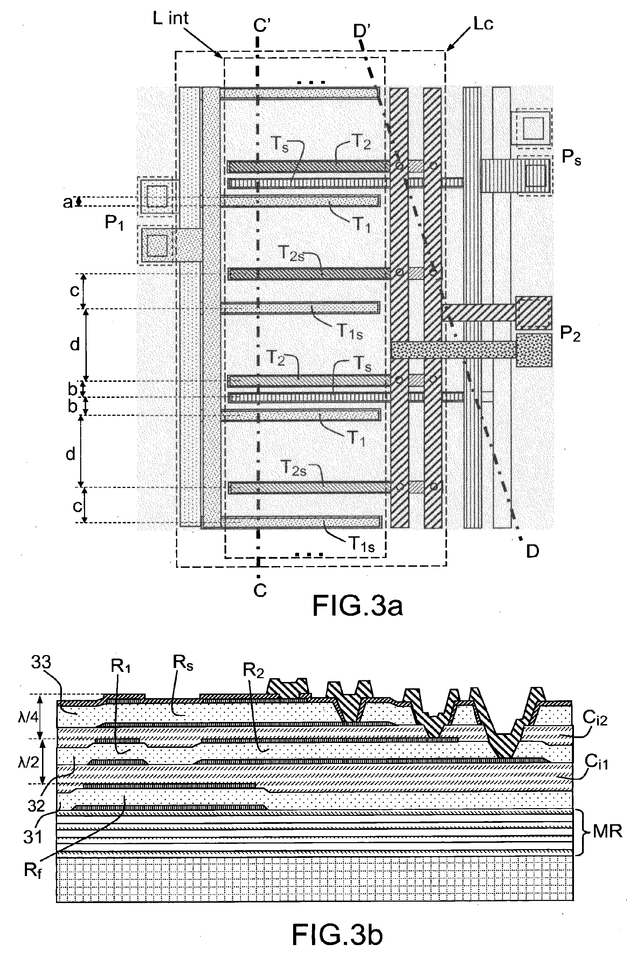

Le Demandeur a lui-même déposé une demande de brevet FR 10 53444, concernant une seconde solution utilisant, elle, des ondes de Lamb ou des ondes de volume, représentées respectivement en figure 3a et 3b. Outre le fait que ces solutions exploitent différents types d'ondes acoustiques pour transporter le signal des ports d'entrée vers un même port de sortie, elles présentent l'intérêt de fournir une isolation entre les ports d'entrée. Pour le mode de réalisation utilisant des ondes de Lamb, ceci est obtenu en disposant le long d'un même axe de propagation des électrodes connectées aux différents ports de manière à ce qu'elles présentent des distances bien définies entre elles. Ces distances permettent ainsi pour des ondes se propageant des électrodes d'émission vers les électrodes de réception de former des interférences constructives, et ainsi de cumuler leurs signaux, et à l'inverse de former des interférences destructives au niveau des ports d'entrée, ce qui garantit l'isolation entre les différentes entrées. Selon ce principe, pour parvenir à entrelacer trois réseaux d'électrodes, il est nécessaire de recourir à la réalisation d'interconnexions permettant aux pistes électriques (par exemple du port de sortie) d'enjamber d'autres connexions électriques (par exemples celles du port 2). Ce principe peut s'avérer complexe à réaliser. Pour le mode de réalisation utilisant des ondes de volume, on reprend l'idée d'utiliser deux chemins acoustiques, mais cette fois-ci verticaux. Le long de chaque chemin acoustique on dispose 3 séries de transducteurs (des couches piézoélectriques prises en sandwich entre deux électrodes), reliées de haut en bas au port de sortie, à l'un des deux ports d'entrée, puis à un port flottant. Par un choix judicieux des épaisseurs des différentes couches de l'empilement, on parvient à obtenir des déphasages entre les ondes provoquant des interférences constructives pour celles se propageant des ports d'entrée vers les ports de sortie, et des interférences destructives pour celles se propageant d'un port d'entrée vers un autre port de sortie, assurant là aussi une isolation électrique entre les ports d'entrée. Ce mode de réalisation requiert l'empilement de trois jeux de couches piézoélectriques, ce qui, en termes de complexité de réalisation peut surpasser un filtre à couplage longitudinal (CRF, pour *Coupled Resonator Filter*), qui lui-même est déjà un composant si complexe à réaliser qu'il n'est à l'heure actuelle pas proposé commercialement comme décrit dans l'article de C. Billard, N. Buffet, S. Joblot, A. Reinhardt, G. Parat, P. Bar, 200 mm manufacturing solution for coupled resonator filters, ESSDERC 2009.

Il apparait ainsi que le brevet FR 10 53444 propose des composants assurant une fonction de combineur de puissance, et de plus une isolation des ports d'entrée (ou de sortie dans le cas du séparateur) qui sont fortement miniaturisables et intégrables, mais qui peuvent se montrer complexes à réaliser et nécessiter la mise au point de procédés de réalisation spécifiques.

Dans ce contexte la présente invention a pour objet un nouveau type de structure de dispositif de puissance pouvant être un combineur ou un diviseur utilisant la propagation d'ondes acoustiques afin de miniaturiser le composant et de faciliter son intégration dans des architectures mobiles, assurant une isolation des ports d'entrée, mais pouvant être réalisé avec des procédés industriels existants.

Plus précisément la présente invention a pour objet un dispositif de puissance selon la revendication 1 ou la revendication 2.

L'utilisation de transducteurs dits flottants permet de transférer une partie de la puissance des ondes circulant dans une des voies acoustiques vers l'autre voie, et ainsi d'assurer des conditions de phase ou d'opposition de phase qui permettent de combiner les signaux qui réalisent des interférences constructives entre eux, et de ne pas combiner ceux qui réalisent des interférences destructives.

Selon une variante de l'invention, les transducteurs sont des transducteurs à ondes de surface.

Selon une variante de l'invention, les transducteurs sont des transducteurs à ondes de plaque.

Selon une variante de l'invention, les transducteurs sont des transducteurs à ondes d'interface.

De préférence, les transducteurs d'entrée, de sortie et flottants sont réalisés à partir d'une même couche de matériau piézoélectrique. On entend par couche, aussi bien un film de matériau qu'un substrat de ce matériau.

Selon un mode particulier de l'invention, les transducteurs à ondes acoustiques comprenant des peignes d'électrodes interdigitées, ledit transducteur d'entrée comprend une partie de ses électrodes connectée à une première masse électrique, ledit transducteur de sortie comprenant également une partie de ses électrodes connectées à ladite première masse électrique et ledit transducteur flottant comprenant une partie de ses électrodes connectées à une masse électrique dite flottante.

Selon un autre mode de réalisation, les peignes des transducteurs sont montés en différentiel et ne sont pas reliés à une masse électrique.

Selon une variante de l'invention, ladite masse flottante est ladite première masse.

Selon une variante de l'invention, chaque voie acoustique comprend une série de groupes Gᵢⱼ de transducteurs selon la revendication 7.

Selon la variante de l'invention selon la revendication 1, dans une même ième voie acoustique, le transducteur d'entrée d'un groupe Gᵢⱼ d'une ième voie acoustique est séparé du transducteur d'entrée du groupe G_{i,(j+1)} de la ième voie acoustique, d'une distance telle qu'une onde acoustique se propageant du groupe Gᵢⱼ au groupe G_{i,(j+1)} subisse un déphasage de 2kπ avec k entier, entre les deux transducteurs d'entrée.

Selon la variante de l'invention selon la revendication 2, dans une même ième voie acoustique, le transducteur de sortie d'un groupe Gᵢⱼ d'une ième voie acoustique est séparé du transducteur de sortie du groupe G_{i,(j+1)} d'une distance telle qu'une onde acoustique se propageant du groupe Gᵢⱼ au groupe G_{i,(j+1)} subisse un déphasage de 2kπ avec k entier, entre les deux transducteurs de sortie.

Selon une variante de l'invention, chaque voie acoustique comprend des réflecteurs acoustiques à chacune de ses extrémités.

Selon une variante de l'invention, les réflecteurs sont des réseaux de peignes interdigités court-circuités.

L'invention sera mieux comprise et d'autres avantages apparaîtront à la lecture de la description qui va suivre donnée à titre non limitatif et grâce aux figures annexées parmi lesquelles :
- les figures 1a et 1b illustrent respectivement des combineurs ou diviseurs de puissance réalisés sous forme de lignes de transmission avec isolation des ports d'entrée et sans isolation particulière selon l'art connu ;
- la figure 2 illustre un diviseur de puissance selon la solution proposée dans le brevet japonais JP 60160719 ;
- les figures 3a et 3b illustrent des solutions utilisant respectivement des ondes de Lamb avec transducteurs entrelacés et des transducteurs à ondes de volume ;
- la figure 4 illustre un exemple de structure d'électrodes de combineur à ondes acoustiques comprenant deux voies acoustiques avec deux ports d'entrée ;
- la figure 5 illustre un exemple de structure d'électrodes de combineur à ondes acoustiques comprenant trois voies acoustiques avec trois ports d'entrée ;
- la figure 6 illustre un exemple de combineur selon l'invention avec plusieurs groupes de transducteurs ;
- la figure 7 illustre le principe de fonctionnement de la combinaison des ondes acoustiques dans un combineur selon l'invention ;
- la figure 8 illustre le principe de fonctionnement concernant le maintien de déphasage nul entre transducteurs reliés à un même port dans un combineur selon l'invention ;
- la figure 9 illustre le principe de fonctionnement du maintien d'une opposition de phase entre transducteurs reliés à des ports d'entrée différents dans un combineur selon l'invention ;
- la figure 10 illustre un exemple de réalisation d'un combineur exploitant des ondes de Lamb dans un combineur selon l'invention ;
- les figures 11a à 11c illustrent les différentes étapes d'un premier exemple de procédé de réalisation d'un combineur selon l'invention ;
- les figures 12a à 12i illustrent les différentes étapes d'un second exemple de procédé de réalisation d'un combineur selon l'invention ;
- les figures 13a à 13f illustrent les différentes étapes d'un troisième exemple de procédé de réalisation d'un combineur selon l'invention.

De manière générale, la présente invention peut aussi bien être appliquée à un dispositif de type combineur que de type diviseur de puissance.

Le combineur utilise n ports d'entrée électriquement isolés entre eux et un port de sortie, le diviseur de manière inverse utilise un port d'entrée et m ports de sortie isolés électriquement entre eux.

Dans la description détaillée ci-après il sera plus précisément décrit le cas de combineur de puissance.

L'objet de la présente invention est donc de proposer une structure de combineur utilisant la propagation d'ondes acoustiques afin de miniaturiser le composant et de faciliter son intégration dans des architectures mobiles, assurant une isolation des ports d'entrée, mais pouvant être réalisée avec des procédés industriels existants.

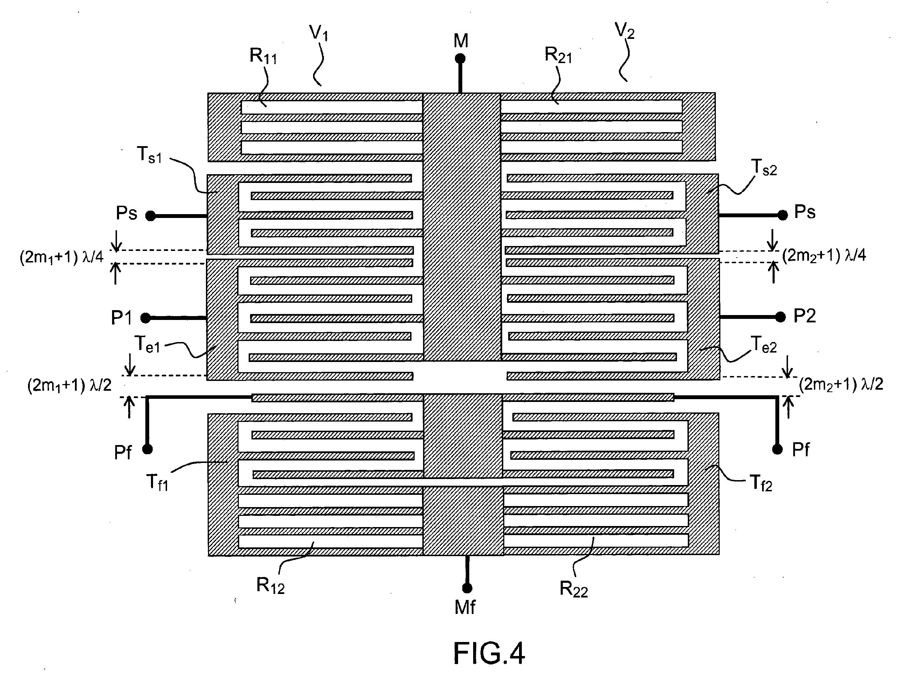

Une structure de combineur à deux ports permettant l'utilisation d'ondes acoustiques de surface selon la présente invention est représentée sur la figure 4.

Une première voie acoustique V₁ comprend :
- un transducteur d'entrée Te₁ à ondes de surface et comprenant une structure de peignes d'électrodes interdigités dont une partie des électrodes est connectée à un premier port d'entrée P₁ l'autre partie des électrodes étant connectée à la masse M ;
- un transducteur de sortie Ts₁ à ondes de surface et comprenant une structure de peignes d'électrodes interdigités dont une partie des électrodes est connectée à un premier port d'entrée Ps l'autre partie des électrodes étant connectée à la masse M ;
- un transducteur dit flottant Tf₁ à ondes de surface et comprenant une structure de peignes d'électrodes interdigités dont une partie des électrodes est connectée à un port interne dit flottant Pf l'autre partie des électrodes étant connectée à une masse M_{f}.

Une seconde voie acoustique V₂ comprend :
- un transducteur d'entrée Te₂ à ondes de surface et comprenant une structure de peignes d'électrodes interdigités dont une partie des électrodes est connectée à un second port d'entrée P₂ l'autre partie des électrodes étant connectée à la masse M ;
- un transducteur de sortie Ts₂ à ondes de surface et comprenant une structure de peignes d'électrodes interdigités dont une partie des électrodes est connectée à un premier port d'entrée Ps l'autre partie des électrodes étant connectée à la masse M ;
- un transducteur dit flottant Tf₂ à ondes de surface et comprenant une structure de peignes d'électrodes interdigités dont une partie des électrodes est connectée à un port interne dit flottant Pf l'autre partie des électrodes étant connectée à une masse M_{f}.

A leurs extrémités, toutes les voies acoustiques sont délimitées par des réseaux de peignes interdigités court-circuités faisant office de réflecteurs acoustiques. Par cette méthode, le couplage acoustique entre les différentes entrées et la sortie est facilité, car il se fait de manière distribuée le long du chemin acoustique. Par ailleurs, la première voie acoustique comprend en outre de part et d'autre de l'ensemble des transducteurs des réflecteurs R₁₁ et R₁₂, la seconde voie acoustique comprenant également de part et d'autre de l'ensemble des transducteurs des réflecteurs R₂₁ et R₂₂.

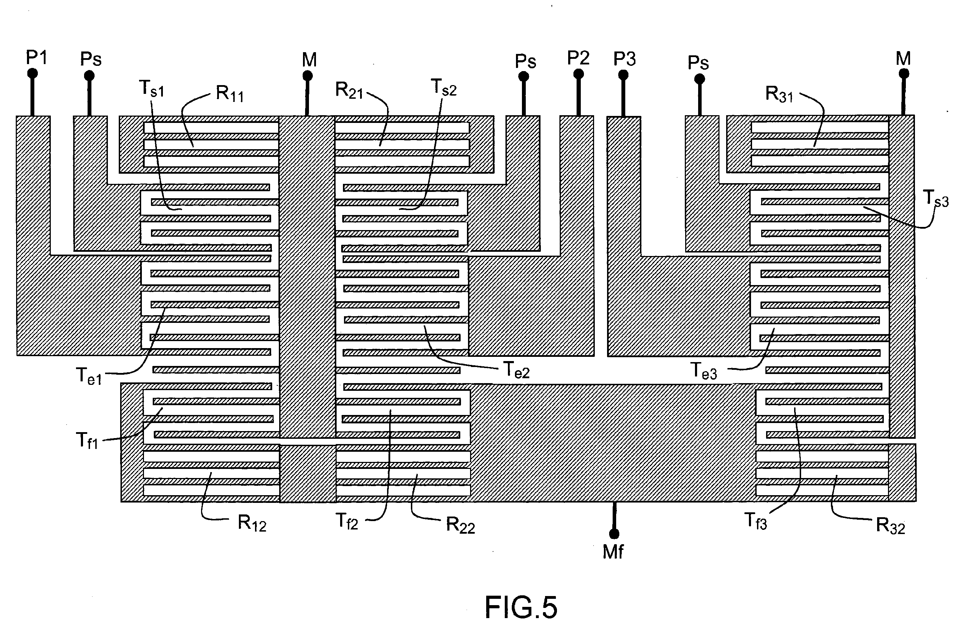

La figure 5 illustre un exemple de configuration de combineur 3 voies acoustiques V₁, V₂ et V₃ selon l'invention.

La troisième voie est de même type que les deux voies acoustiques illustrées en figure 4 et comprend en outre :
- des réflecteurs R₃₁ et R₃₂;
- un transducteur d'entrée Te₃ à ondes de surface et comprenant une structure de peignes d'électrodes interdigités dont une partie des électrodes est connectée à un premier port d'entrée P₃ l'autre partie des électrodes étant connectée à la masse M ;
- un transducteur de sortie Ts₃ à ondes de surface et comprenant une structure de peignes d'électrodes interdigités dont une partie des électrodes est connectée à un troisième port d'entrée Ps l'autre partie des électrodes étant connectée à la masse M ;
- un transducteur dit flottant Tf₃ à ondes de surface et comprenant une structure de peignes d'électrodes interdigités dont une partie des électrodes est connectée à un port interne dit flottant Pf l'autre partie des électrodes étant connectée à une masse Mf.

De manière générale, le transducteur d'entrée est disposé de manière à ce que la distance entre des peignes connectés au port d'entrée et des peignes connectés au port de sortie soit :
- pour la voie V₁, une distance de (2m₁+1)λ/4, où m₁ est un nombre entier et λ la longueur d'onde des ondes exploitées ;
- pour la voie V₂, une distance de (2m₂+1)λ/4, où m₂ est un nombre entier et λ la longueur d'onde des ondes exploitées.

Ceci permet d'établir un signal de sortie en quadrature avec celui du port d'entrée et empêche la réflexion des ondes vers ce même port d'entrée, assurant que le signal ne soit pas renvoyé vers sa source. Comme les électrodes encore couramment dénommés « doigts » des transducteurs d'entrée et de sortie sont disposés avec une périodicité égale à la longueur d'onde à la fréquence visée, cette condition de quadrature est vraie pour toute onde émise sur un doigt quelconque du transducteur d'entrée et parvenant à un autre doigt quelconque du transducteur de sortie.

Dans chacune des voies acoustiques, il est également prévu un autre transducteur dit flottant à peignes interdigités, dont une partie des doigts est connectée à un port interne Pf (flottant) au dispositif, et une autre partie à une masse Mf, ladite masse pouvant être distincte ou non des autres masses.

Ce transducteur dit flottant est disposé de manière à ce que la distance entre une électrode reliée à ce port et une électrode reliée au port d'entrée soit respectivement dans chacune des voies :
- pour la voie V₁ une distance de (2n₁+1) λ /2, avec n₁ un nombre entier ;
- pour la voie V₂, une distance de (2n₂+1) λ /2, avec n₂ un nombre entier.

Comme précédemment, le fait d'avoir toutes les électrodes disposées avec une périodicité égale à la longueur d'onde à la fréquence visée permet d'assurer que le signal récupéré sur ce port flottant est en opposition de phase par rapport au signal du port d'entrée.

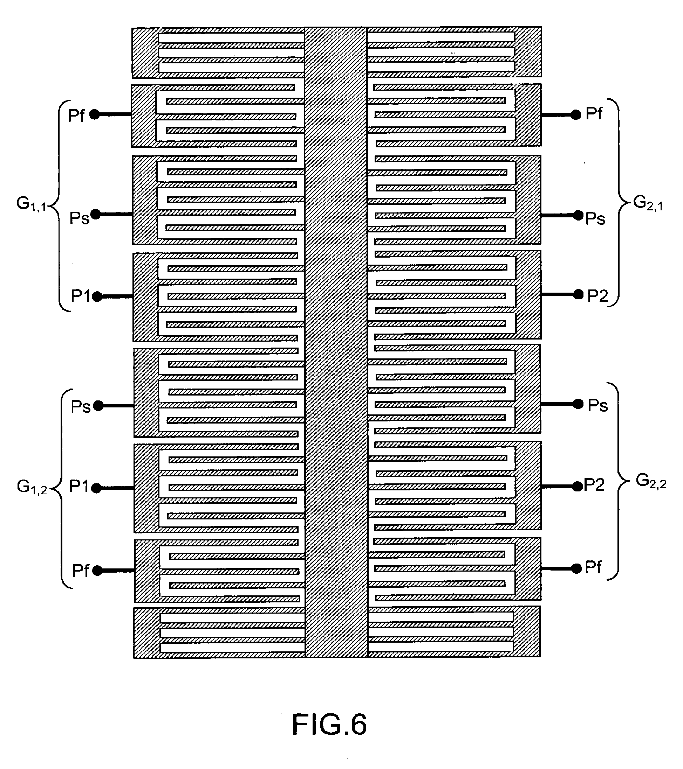

Il est également possible de répéter cette structure le long de l'axe de propagation afin d'augmenter l'efficacité de la conversion d'énergie des entrées vers la sortie en scindant les différents transducteurs. Ceci est illustré sur la figure 6.

Chaque voie acoustique Vi peut comprendre un ensemble de groupe G _{i,j} comprenant lui-même un transducteur d'entrée, un transducteur de sortie et un transducteur dit flottant. La figure 6 est relative au cas i=2 et j=2. Pour ne pas surcharger, la figure, seuls les ports de connexion des transducteurs ont été représentés.

Dans le groupe G_{1,1} : le port flottant P_{f}, le port de sortie Ps, le port d'entrée P₁.

Dans le groupe G_{1,2} : le port de sortie Ps, le port d'entrée P₁, le port flottant Pf.

Dans le groupe G_{2,1} : le port flottant P_{f}, le port de sortie Ps, le port d'entrée P₂.

Dans le groupe G_{2,2} : le port de sortie Ps, le port d'entrée P₂, le port flottant Pf.

Dans tous les cas, pour que le dispositif fournisse les propriétés électriques désirées, il est nécessaire de s'assurer qu'un signal émis au niveau d'un port Pᵢ arrive sur le port de sortie :
- en quadrature de phase par le chemin direct du port Pᵢ au port de sortie Ps ;
- en quadrature de phase également par un chemin passant par les ports : Pᵢ - Pf - Pᵢ - Ps (réflexion en bas du chemin le long de la voie Vᵢ).
- en quadrature de phase également par un chemin passant par les ports Pᵢ - Pfᵢ - Pfⱼ - Pⱼ - Ps (chemin passant par les deux voies acoustiques Vᵢ et Vⱼ).

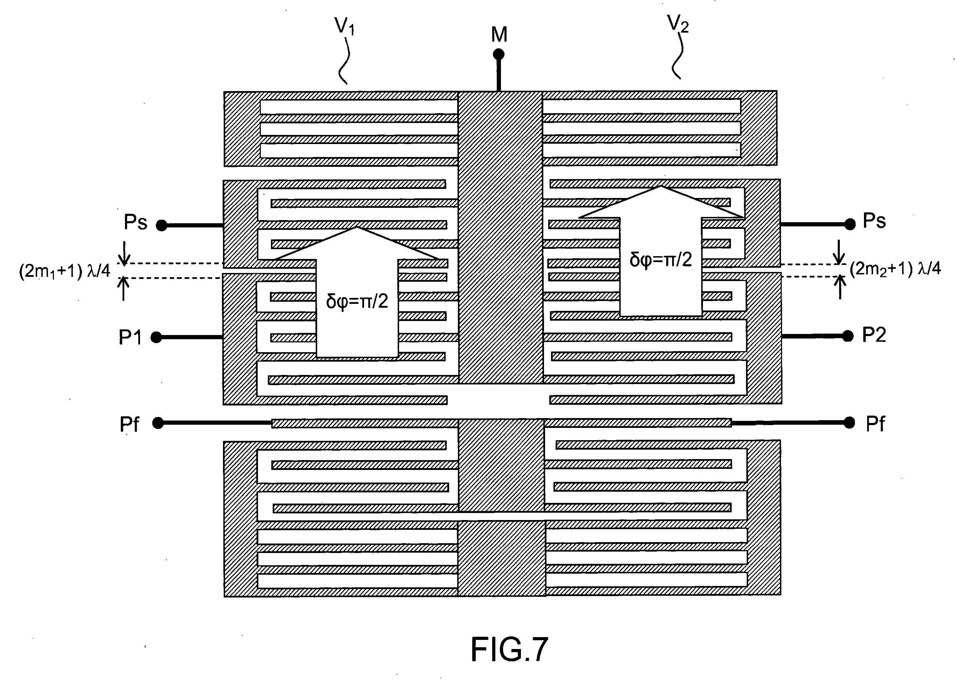

Ceci est bien assuré par l'espacement de (2mᵢ+1)λ/4 (ou (2m₂+1)λ/4) entre les transducteurs d'entée et de sortie et par le fait que tous les peignes reliés à un même port électrique sont disposés avec une distance correspondant à la longueur d'onde λ de l'onde exploitée, comme illustré sur la figure 7.

Par symétrie de la structure, un signal émis au niveau du port j arrive également en quadrature de phase vers le port de sortie, quel que soit le chemin acoustique employé. De ce fait, on génère des interférences constructives entre les ondes émises par les transducteurs d'entrée et parvenant au niveau du transducteur de sortie, et on vient bien sommer (combiner) au niveau de la sortie les signaux appliqués aux ports d'entrée.

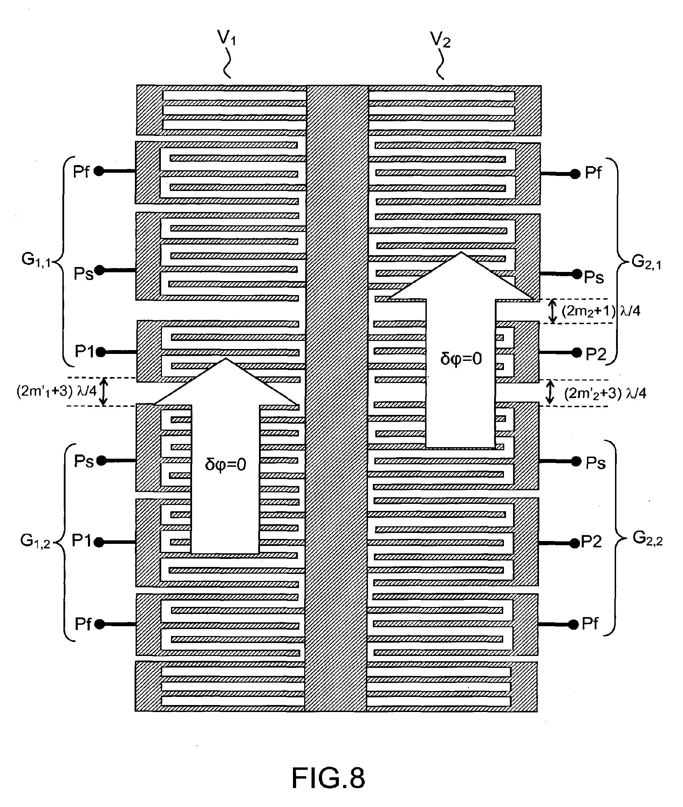

Si les transducteurs d'entrée et de sortie ont été répartis dans la structure, il faut également s'assurer que les ondes émises par ces transducteurs parviennent à une autre partie du transducteur sans subir de déphasage, afin d'assurer des interférences constructives entre les sources acoustiques rattachées à chaque port. Ceci impose, comme illustré sur la figure 8, qu'une onde se propageant subisse un déphasage qui soit un multiple de 2π lors de la propagation d'une électrode d'un transducteur à une électrode d'un autre transducteur.

Comme représenté en figure 8, le groupe G_{1,1} étant séparé du groupe G_{1,2} par une distance égale à (2m'₁ +3) λ/4, ceci se traduit par la condition (2m₁+1)λ/4 + (2m₁'+3)λ/4 = (m₁+m₁'+2)λ/2 = Nλ avec N un nombre entier. Ceci impose d'avoir m₁+m₁' égal à un nombre entier pair.

En ce qui concerne le port de sortie Ps, toujours d'après la même figure, on doit avoir (2m'₂+3)λ/4 + (2m₂+1)λ/4 = (m'₂+m₂+4)λ/2 = Nλ, soit encore m'₂+m₂ devant également être égal à un nombre entier pair.

Il est à noter que selon cet exemple de configuration, il a été choisi une distance de (2m'+3)λ/4 entre deux groupes d'une même voie, afin d'inverser l'alternance des peignes interdigités d'un transducteur à l'autre. Il aurait également été possible de considérer de manière générique un espacement de (2m'+1) λ/4, et parvenir dans ce cas à la conclusion que m+m' doit être égal à un nombre entier impair.

Plus généralement, ces conditions reviennent à dire que la polarité des transducteurs reliés à un même port doit être inversée.

Les conditions précédemment décrites permettent d'obtenir des interférences constructives pour des ondes émises à un port, et se propageant vers le même port, ou vers le port de sortie. Ces conditions assurent ainsi que l'on vient combiner les signaux. Par contre, par elles-mêmes, elles n'assurent pas l'isolation entre les ports d'entrée. Pour ce faire, il est nécessaire que, pour des ondes se propageant entre deux transducteurs d'entrée, un signal émis par un port P₁ arrive :
- en opposition de phase par le chemin port P₁ - port de sortie Ps (voie 1) - port de sortie Ps (voie 2) - port P₂.
- en phase par le chemin port P₁ - port Pf - port flottant Pf - port P₂.

Il se produit ainsi des interférences destructives au niveau du port P₂ entre les ondes ayant emprunté ces deux chemins différents, ce qui assure l'isolation entre les deux entrées électriques.

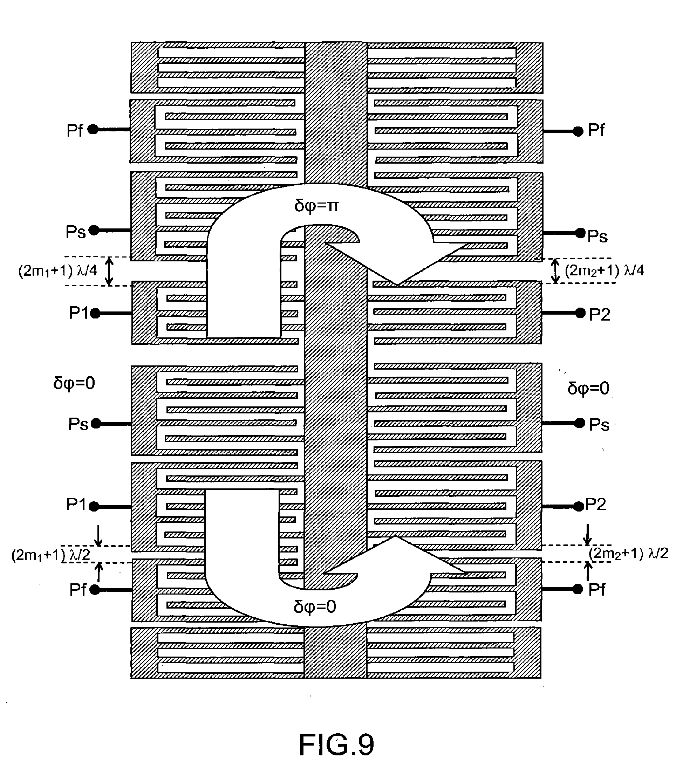

Comme illustré sur la figure 9, l'opposition de phase est obtenue dès que les espacements entre transducteurs présentent les conditions suivantes :
- (2m₁+1)λ/4+(2m₂+1) λ/4 = (m₁+m₂+1) λ/2 = (2N+1) λ/2, ce qui impose que m₁+m₂ doit être un nombre entier pair ;
- (2n₁+1) λ/2 + (2n₂+1) λ/2 = (n₁+n₂+1) λ = N' λ, ce qui finalement n'impose pas de condition particulière sur n₁+n₂.

Il est à remarquer que l'homme de métier saura adapter au mieux ces principes directeurs. Notamment, les distances entre transducteurs sont indicatives, et pourront être modifiées légèrement pour compenser un retard électrique provoqué par la propagation du signal électrique le long des réseaux d'électrodes dans le cas où les transducteurs utilisés comportent un grand nombre de doigts et où l'on opère à haute fréquence (où les longueurs d'onde électriques commencent à devenir comparables avec les dimensions d'un dispositif, ce qui peut se traduire par des retards à la propagation des courants et tensions le long des électrodes, qu'il faut alors compenser).

La présente invention, par rapport aux solutions présentées précédemment, permet de réaliser un combineur acoustique avec isolation des ports d'entrée tout en utilisant les procédés de réalisation de composants à ondes acoustiques de surface existants. Les principes exposés ne tirent en effet aucunement partie de propriétés particulières d'un procédé ou d'un empilement donné et ce aussi bien dans le cadre de composants à ondes acoustiques de surface, que de composants à ondes d'interface ou de plaque.

### Exemple de réalisation d'un combineur à ondes de lamb selon l'invention :

Le combineur acoustique à ondes de Lamb utilise des ondes se propageant dans une plaque simple de nitrure d'aluminium (AIN) et confinées dans cette plaque grâce à leur réflexion aux interfaces solide / air.

Sous cette plaque sont disposées des électrodes de Molybdène (Mo) de 200 nm d'épaisseur. Au dessus de cette plaque sont localisées des électrodes en alliage d'Aluminium / Silicium (AISi) de 200 nm d'épaisseur également. Pour des raisons de procédé de réalisation, l'ensemble des transducteurs est protégé par une couche d'oxyde de silicium (SiO₂) de 500 nm d'épaisseur.

Dans un tel empilement, les ondes de Lamb se propagent à une vitesse de 7800 m/s en présence des métallisations, et de 8400 m/s en l'absence d'électrode supérieure. Ces vitesses peuvent être calculées par diverses méthodes décrites dans la littérature : par éléments finis ou par des méthodes numériques telles que par exemple la matrice de réflexion (*scattering matrix method* en anglais), comme décrit par exemple dans les articles de A. Reinhardt, V. Laude, M. Solal, S. Ballandras, W. Steichen, Investigation of spurious resonances in Thin Film Bulk Acoustic Wave Resonators, Proceedings of the 2004 IEEE Ultrasonics Symposium ou de A. Reinhardt, S. Ballandras et V. Laude, Simulation of transverse effects in FBAR devices, 2005 IEEE MTT-S Digest

Pour réaliser un combineur acoustique à deux ports d'entrée P₁ et P₂ on prévoit de réaliser 4 transducteurs d'entrée Te₁₁, Te₁₂, Te₂₁, Te₂₂ à partir de deux transducteurs divisés et connectés aux deux ports d'entrée P₁ et P₂ en deux, et de les disposer de part et d'autre de transducteurs Ts₁ et Ts₂ connectés au port de sortie Ps. Chaque chemin acoustique est terminé par un transducteur flottant Tf₁₁, Tf₁₂, Tf₂₁ et Tf₂₂, servant à assurer la liaison électrique entre les deux chemins acoustiques.

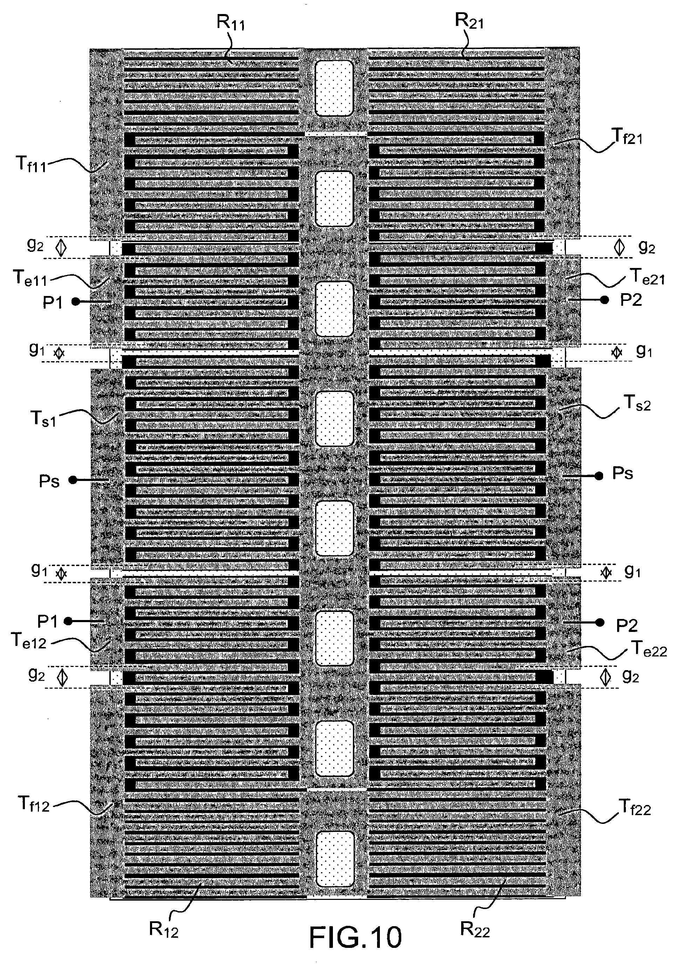

Chaque transducteur est constitué de peignes interdigités réalisés au niveau de l'électrode supérieure, et d'un plan métallique flottant réalisé au niveau de l'électrode inférieure. Arbitrairement, on peut choisir une longueur de 10 doigts pour chaque transducteur d'entrée et pour les transducteurs flottants, contre 20 pour les transducteurs connectés aux ports de sortie. Enfin, l'ensemble de la structure est encadré par des réseaux de réflecteurs comprenant R₁₁, R₁₂, R₂₁, R₂₂, une centaine de doigts court-circuités. La structure obtenue est représentée sur la figure 10.

La largeur *a* des électrodes des peignes interdigités est prise comme égale à un quart de longueur d'onde sous les peignes, soit approximativement 1 µm à une fréquence de 2 GHz. La distance entre les doigts d'un même transducteur est également prise comme égale à 1 µm. Les seules dérogations à cette règle sont les distances entre transducteurs :
- du centre d'un doigt du transducteur extrême du port 1 (ou 2) au doigt le plus proche du port de sortie, on impose une distance *g₁* égale à 3.1 µm (soit approximativement 3 λ/4)
- du centre d'un doigt du transducteur extrême du port 1 (ou 2) au doigt le plus proche du port flottant, on impose une distance *g₂* égale à 6.25 µm (soit approximativement 3 λ/2)
Avec un total de 260 électrodes, une telle structure possède un encombrement de l'ordre de 500 x 500 µm², soit bien moins qu'une structure équivalente réalisée par des lignes de transmission micro-ondes classiques opérant à la même fréquence.

### Premier exemple de procédé de fabrication de l'exemple de combineur à ondes de surface :

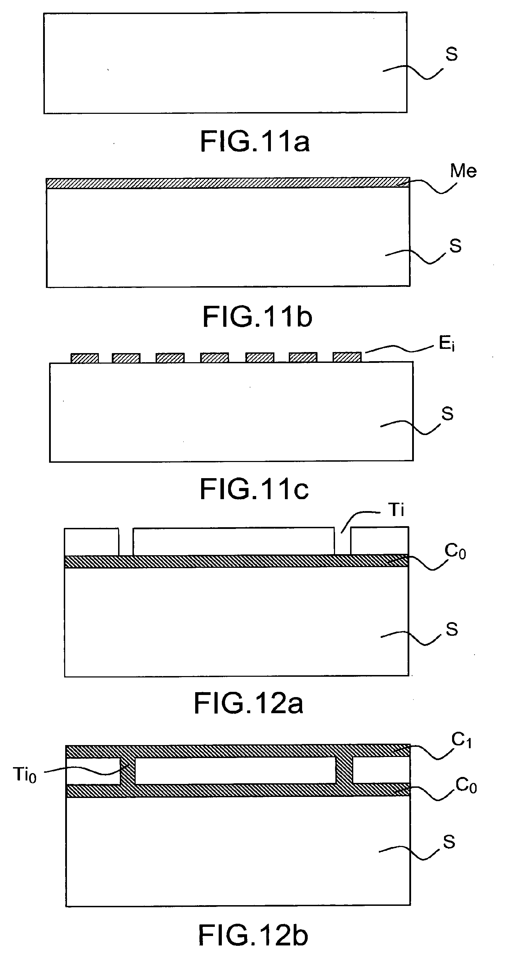

Les différentes étapes du procédé sont illustrées par les figures 11a à 11c.

L'étape 1 est illustrée en figure 11a : on procède au nettoyage d'un substrat piézoélectrique S (pouvant être de tout type de matériau piézoélectrique, par exemple en quartz, niobate de lithium, tantalate de lithium, langasite, langatate, ...) et possédant toute orientation cristalline amenant à l'utilisation d'ondes présentant les caractéristiques recherchées permettant d'amener une fréquence, une gamme de fréquences de fonctionnement et un niveau de pertes désiré.

L'étape 2 est illustrée en figure 11b : on dépose une couche de métal Me (par exemple Aluminium, mais cela pourrait également être de Molybdène, de Tungstène, de Ruthénium, de Cuivre, d'Or, ...) par pulvérisation cathodique, à la surface du substrat S.

L'étape 3 est illustrée en figure 11c : on procède à des étapes de photolithographie classiques, gravure sèche puis retrait de la résine pour définir les architectures d'électrodes surfaciques Ei.

### Deuxième exemple de procédé de fabrication d'un combineur à ondes acoustiques de Lamb selon l'invention :

Les différentes étapes du procédé sont illustrées par les figures 12a à 12i

L'étape 1 illustrée en figure 12a est relative à la réalisation de tranchées Ti dans un substrat SOI (pour Silicon on Insulator) par gravure sèche du silicium, comprenant un substrat de silicium S et incorporant une couche de diélectrique Cₒ.

L'étape 2 illustrée en figure 12b est relative à une opération d'oxydation thermique de manière à reboucher les tranchées préalablement formées lors de la croissance de l'oxyde de silicium. On définit ainsi les bords (Tio, C₁) d'un caisson qui permettra de constituer une cavité d'air sous la membrane piézoélectrique.

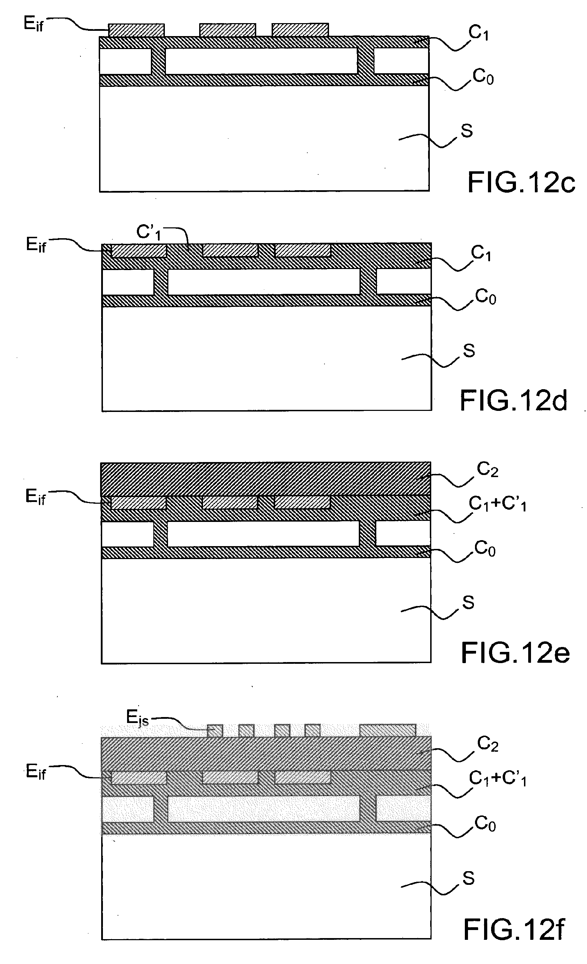

L'étape 3 illustrée en figure 12c est relative au dépôt et à la structuration d'une couche (par photolithographie, gravure sèche fluorée et retrait de résine) permettant de définir des électrodes inférieures Ei_{f} en molybdène.

L'étape 4 illustrée en figure 12d est relative au dépôt d'une couche d'oxyde de silicium C₁' (par exemple par « PECVD »), puis planarisation mécano-chimique de type « CMP » venant affleurer au niveau du sommet des électrodes métalliques, afin de fournir une surface parfaitement plane.

L'étape 5 illustrée en figure 12e est relative au dépôt d'une couche de nitrure d'aluminium C₂ (par pulvérisation cathodique réactive DC pulsée).

L'étape 6 illustrée en figure 12f est relative au dépôt d'une couche de d'AISi par pulvérisation puis à la définition des électrodes supérieures Ejₛ par lithographie, gravure sèche chlorée, puis retrait de résine.

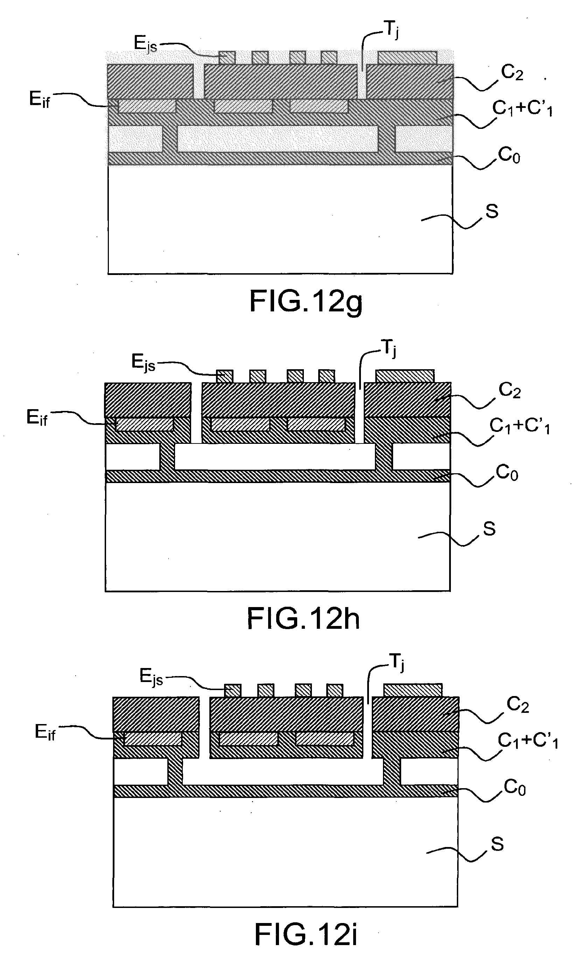

L'étape 7 illustrée en figure 12g est relative à des étapes de lithographie, attaque de cette couche d'AIN par gravure sèche chlorée afin de définir des ouvertures de libération Tj.

L'étape 8 illustrée en figure 12h est relative à une opération de gravure sèche fluorée de l'oxyde de silicium situé sous l'AIN, puis retrait de résine au travers des couches C₁ et C₁'.

L'étape 9 illustrée en figure 12i est relative à une opération de gravure du silicium dans les caissons préalables définis par l'étape 2, par XeF2 gazeux.

### Troisième exemple de procédé de fabrication d'un combineur utilisant des ondes guidées dans une couche piézoélectrique déposée sur un miroir de Bragg acoustique selon l'invention :

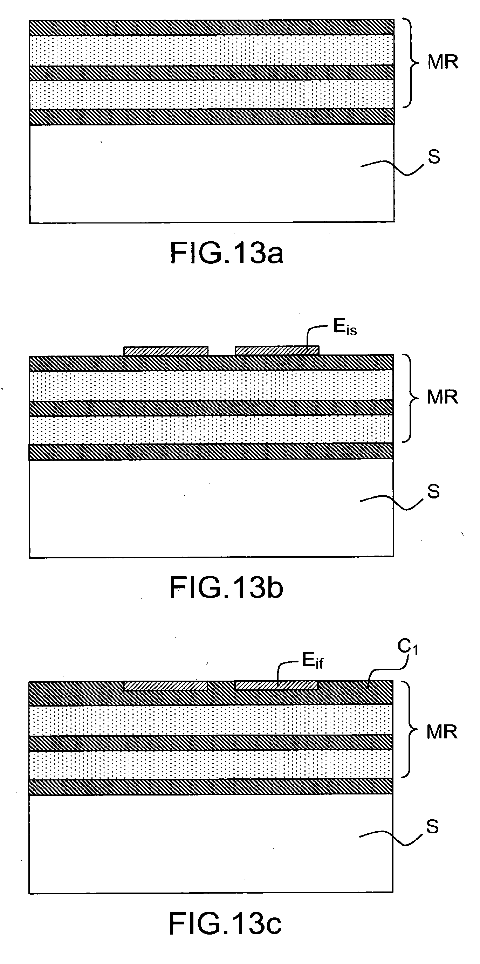

Les différentes étapes du procédé sont illustrées par les figures 13a à 13f.

L'étape 1 illustrée en figure 13a est relative au dépôt alternativement de couches de SiOC, SiN, SiOC, SiN,SiOC par PECVD afin de former un miroir de Bragg acoustique MR, à la surface d'un substrat S.

L'étape 2 illustrée en figure 13b est relative au dépôt d'une couche de molybdène par pulvérisation cathodique. On procède alors à des opérations de photolithographie, gravure sèche fluorée, puis retrait de résine, pour définir les électrodes inférieures Ei_{f}

L'étape 3 illustrée en figure 13c est relative au dépôt d'une couche d'oxyde de silicium C₁ par « PECVD », puis polissage mécano-chimique « CMP » pour planariser la surface de la plaque en venant affleurer au niveau des électrodes inférieures.

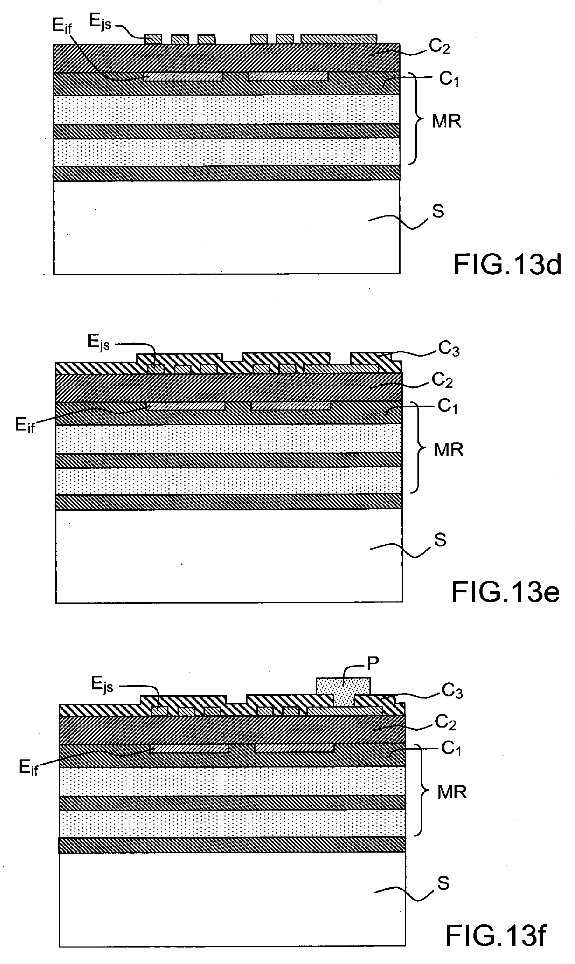

L'étape 4 illustrée en figure 13d est relative au dépôt d'une couche C₂ de nitrure d'aluminium par pulvérisation cathodique réactive DC pulsée, puis d'une couche de molybdène par pulvérisation cathodique. Des étapes de photolithographie, gravure sèche fluorée, puis retrait de résine permettent de définir les électrodes supérieures Ejₛ.

L'étape 5 illustrée en figure 13e est relative au dépôt d'une couche de passivation C₃ en nitrure de silicium par PECVD, puis à des opérations de photolithographie, gravure sèche et retrait de résine pour définir des ouvertures Tₖ dans la couche de passivation permettant un contact électrique vers l'électrode supérieure.

L'étape 6 illustrée en figure 13f est relative au dépôt d'une couche d'aluminium (d'environ 1 µm) par pulvérisation. Des étapes de photolithographie, gravure sèche chlorée, puis retrait de résine permettent alors la formation de plots de contacts P.

## Revendications

1. Dispositif de puissance comprenant un port de sortie (Ps) et au moins une première voie acoustique et une seconde voie acoustique, chaque voie acoustique comportant au moins un premier transducteur à ondes acoustiques dit d'entrée (Te₁, Te₂) connecté à un port d'entrée (P₁, P₂), et un transducteur à ondes acoustiques dit de sortie (Ts₁, Ts₂) **caractérisé en ce que** :
- chaque voie acoustique comporte en outre un transducteur à ondes acoustiques dit flottant (Tf₁, Tf₂) connecté à un port dit flottant (Pf) ;
- le transducteur d'entrée et le transducteur de sortie étant séparés par une distance égale à (2m+1)λ/4 avec m entier et λ la longueur d'onde de propagation ;
- le transducteur d'entrée et le transducteur flottant étant séparés par une distance égale à (2n+1) λ/2 avec n entier ;
- chaque transducteur de sortie étant connecté au port de sortie (Ps), ledit dispositif de puissance étant un combineur.

2. Dispositif de puissance comprenant un port d'entrée (Pe) et au moins une première voie acoustique et une seconde voie acoustique chaque voie acoustique comportant au moins un premier transducteur à ondes acoustiques dit d'entrée (Te₁, Te₂) et un transducteur à ondes acoustiques dit de sortie (Ts₁, Ts₂) connecté à un port de sortie (Ps₁, Ps₂) **caractérisé en ce que** :
- chaque voie acoustique comporte en outre un transducteur à ondes acoustiques dit flottant (Tf₁, Tf₂) connecté à un port dit flottant (Pf) ;
- le transducteur d'entrée et le transducteur de sortie étant séparés par une distance égale à (2m+1)λ/4 avec m entier ;
- le transducteur de sortie et le transducteur flottant étant séparés par une distance égale à (2n+1) λ/2 avec n entier et λ la longueur d'onde de propagation ;
- chaque transducteur d'entrée étant connecté au port d'entrée (Pe), ledit dispositif de puissance étant un diviseur.

3. Dispositif de puissance selon l'une des revendications 1 ou 2, **caractérisé en ce que** les transducteurs sont des transducteurs à ondes de surface.

4. Dispositif de puissance selon l'une des revendications 1 ou 2, **caractérisé en ce que** les transducteurs sont des transducteurs à ondes de plaque.

5. Dispositif de puissance selon l'une des revendications 1 ou 2, **caractérisé en ce que** les transducteurs sont des transducteurs à ondes d'interface.

6. Dispositif de puissance selon l'une des revendications 1 à 5, **caractérisé en ce que** les transducteurs d'entrée, de sortie et flottants sont réalisés à partir d'une même couche de matériau piézoélectrique.

7. Dispositif de puissance selon l'une des revendications 1 à 6, **caractérisé en ce que** chaque voie acoustique répète le long de l'axe de propagation la structure comprenant le transducteur d'entrée, le transducteur de sortie et le transducteur flottant et forme ainsi une série de groupes Gᵢⱼ de transducteurs, chaque groupe comportant ainsi un transducteur d'entrée, un transducteur de sortie et un transducteur flottant, ladite série de groupes permettant d'augmenter l'efficacité de conversion d'énergie entre les entrées et les sorties.

8. Dispositif de puissance selon la revendication 7 dans la mesure où elle se réfère à un combineur selon la revendication 1 **caractérisé en ce que** dans une même ième voie acoustique, le transducteur d'entrée d'un groupe Gᵢⱼ d'une ième voie acoustique est séparé du transducteur d'entrée du groupe G_{i,(j+1}) d'une distance telle qu'une onde acoustique se propageant du groupe Gᵢⱼ au groupe G_{i,(j+1}) subisse un déphasage de 2kπ avec k entier, entre les deux transducteurs d'entrée.

9. Dispositif de puissance selon la revendication 7 dans la mesure où elle se réfère à un diviseur selon la revendication 2 **caractérisé en ce que** dans une même ième voie acoustique, le transducteur de sortie d'un groupe Gᵢⱼd'une ième voie acoustique est séparé du transducteur de sortie du groupe G_{i,(j+1}) d'une distance telle qu'une onde acoustique se propageant du groupe Gᵢⱼ au groupe G_{i,(j+1)} subisse un déphasage de 2kπ avec k entier entre les deux transducteurs de sortie.

10. Dispositif de puissance selon l'une des revendications 1 à 9, **caractérisé en ce que** chaque voie acoustique comprend des réflecteurs acoustiques à chacune de ses extrémités.

11. Dispositif de puissance selon la revendication 10, **caractérisé en ce que** les réflecteurs sont des réseaux de peignes interdigités court-circuités.

## Patentansprüche

1. Leistungsgerät, das einen Ausgangsport (Ps) und wenigstens einen ersten akustischen Kanal und einen zweiten akustischen Kanal umfasst, wobei jeder akustische Kanal wenigstens einen mit einem Eingangsport (P₁, P₂) verbundenen, Eingangswandler (Te₁, Te₂) genannten ersten Wandler für akustische Wellen und einen Ausgangswandler (Ts₁, Ts₂) genannten Wandler für akustische Wellen umfasst, **dadurch gekennzeichnet, dass**:
- jeder akustische Kanal ferner einen schwebender Wandler (Tf₁, Tf₂) genannten Wandler für akustische Wellen umfasst, der mit einem schwebender Port (Pf) genannten Port verbunden ist;
- der Eingangswandler und der Ausgangswandler durch einen Abstand von gleich (2m+1)λ/4 voneinander getrennt sind, wobei m eine ganze Zahl ist und λ die Ausbreitungswellenlänge ist;
- der Eingangswandler und der schwebende Wandler durch einen Abstand von gleich (2n+1)λ/2 voneinander getrennt sind, wobei n eine ganze Zahl ist;
- jeder Ausgangswandler mit dem Ausgangsport (Ps) verbunden ist, wobei das Leistungsgerät ein Koppler ist.

2. Leistungsgerät, das einen Eingangsport (Pe) und wenigstens einen ersten akustischen Kanal und einen zweiten akustischen Kanal umfasst, wobei jeder akustische Kanal wenigstens einen Eingangswandler (Te₁, Te₂) genannten ersten Wandler für akustische Wellen und einen Ausgangswandler (Ts₁, Ts₂) genannten, mit einem Ausgangsport (Ps₁, Ps₂) verbundenen Wandler für akustische Wellen umfasst, **dadurch gekennzeichnet, dass**:
- jeder akustische Kanal ferner einen schwebender Wandler (Tf₁, Tf₂) genannten Wandler für akustische Wellen umfasst, der mit einem schwebender Port (Pf) genannten Port verbunden ist;
- der Eingangswandler und der Ausgangswandler durch einen Abstand von gleich (2m+1)λ/4 voneinander getrennt sind, wobei m eine ganze Zahl ist;
- der Ausgangswandler und der schwebende Wandler durch einen Abstand von gleich (2n+1)λ/2 voneinander getrennt sind, wobei n eine ganze Zahl ist und λ die Ausbreitungswellenlänge ist;
- jeder Eingangswandler mit dem Eingangsport (Pe) verbunden ist, wobei das Leistungsgerät ein Splitter ist.

3. Leistungsgerät nach Anspruch 1 oder 2, **dadurch gekennzeichnet, dass** die Wandler Oberflächenwellenwandler sind.

4. Leistungsgerät nach Anspruch 1 oder 2, **dadurch gekennzeichnet, dass** die Wandler Plattenwellenwandler sind.

5. Leistungsgerät nach Anspruch 1 oder 2, **dadurch gekennzeichnet, dass** die Wandler Grenzflächenwellenwandler sind.

6. Leistungsgerät nach einem der Ansprüche 1 bis 5, **dadurch gekennzeichnet, dass** der Eingangs-, Ausgangs- und schwebende Wandler von einer selben Schicht aus piezoelektrischem Material erzeugt werden.

7. Leistungsgerät nach einem der Ansprüche 1 bis 6, **dadurch gekennzeichnet, dass** jeder akustische Kanal, entlang der Ausbreitungsachse, die Struktur wiederholt, die den Eingangswandler, den Ausgangswandler und den schwebenden Wandler umfasst und somit eine Serie von Gruppen Gᵢⱼ von Wandlern bildet, wobei jede Gruppe dann einen Eingangswandler, einen Ausgangswandler und einen schwebenden Wandler umfasst, wobei die Serie von Gruppen eine Verbesserung der Energieumwandlungseffizienz zwischen Eingängen und Ausgängen zulässt.

8. Leistungsgerät nach Anspruch 7 in Abhängigkeit von einem Koppler nach Anspruch 1, **dadurch gekennzeichnet, dass** in einem selben n-ten akustischen Kanal der Eingangswandler einer Gruppe Gᵢⱼ eines n-ten akustischen Kanals vom Eingangswandler der Gruppe G_{i,(j+1)} um einen solchen Abstand getrennt ist, so dass eine sich von der Gruppe Gᵢⱼ zur Gruppe G_{i,(j+1)} ausbreitende akustische Welle eine Phasenverschiebung von 2kπ, wobei k eine ganze Zahl ist, zwischen den beiden Eingangswandlern erfährt.

9. Leistungsgerät nach Anspruch 7 in Abhängigkeit von einem Splitter nach Anspruch 2, **dadurch gekennzeichnet, dass** in einem selben n-ten akustischen Kanal der Ausgangswandler einer Gruppe Gᵢⱼ eines n-ten akustischen Kanals vom Ausgangswandler der Gruppe G_{i,(j+1)} um einen solchen Abstand getrennt ist, dass eine sich von der Gruppe Gᵢⱼ zur Gruppe G_{i,(i+1)} ausbreitende akustische Welle eine Phasenverschiebung von 2kπ, wobei k eine ganze Zahl ist, zwischen den beiden Ausgangswandlern erfährt.

10. Leistungsgerät nach einem der Ansprüche 1 bis 9, **dadurch gekennzeichnet, dass** jeder akustische Kanal akustische Reflektoren an beiden Enden umfasst.

11. Leistungsgerät nach Anspruch 10, **dadurch gekennzeichnet, dass** die Reflektoren kurzgeschlossene, kammartig ineinandergreifende Anordnungen sind.

## Claims

1. A power device comprising an output port (Ps) and at least one first acoustic channel and one second acoustic channel, each acoustic channel comprising at least one first acoustic wave transducer, called input transducer (Te₁, Te₂), connected to an input port (P₁, P₂), and an acoustic wave transducer, called output transducer (Ts₁, Ts₂), **characterised in that**:
- each acoustic channel further comprises an acoustic wave transducer, called floating transducer (Tf₁, Tf₂), connected to a port, called floating port (Pf);
- said input transducer and said output transducer are separated by a distance equal to (2m+1)λ/4, with m being an integer and λ being the propagation wavelength;
- said input transducer and said floating transducer are separated by a distance equal to (2n+1)λ/2, with n being an integer;
- each output transducer is connected to said output port (Ps), with said power device being a combiner.

2. A power device comprising an input port (Pe) and at least one first acoustic channel and one second acoustic channel, each acoustic channel comprising at least one first acoustic wave transducer, called input transducer (Te₁, Te₂), and an acoustic wave transducer, called output transducer (Ts₁, Ts₂), connected to an output port (Ps₁, Ps₂), **characterised in that**:
- each acoustic channel further comprises an acoustic wave transducer, called floating transducer (Tf₁, Tf₂), connected to a port, called floating port (Pf);
- said input transducer and said output transducer are separated by a distance equal to (2m+1)λ/4, with m being an integer;
- said output transducer and said floating transducer are separated by a distance equal to (2n+1)λ/2, with n being an integer and λ being the propagation wavelength;
- each input transducer is connected to said input port (Pe), with said power device being a splitter.

3. The power device according to claim 1 or 2, **characterised in that** said transducers are surface wave transducers.

4. The power device according to claim 1 or 2, **characterised in that** said transducers are plate wave transducers.

5. The power device according to claim 1 or 2, **characterised in that** said transducers are interface wave transducers.

6. The power device according to any one of claims 1 to 5, **characterised in that** said input, output and floating transducers are produced from the same layer of piezoelectric material.

7. The power device according to any one of claims 1 to 6, **characterised in that** each acoustic channel repeats, along the propagation axis, the structure comprising said input transducer, said output transducer and said floating transducer and thus forms a series of groups Gᵢⱼ of transducers, each group then comprising an input transducer, an output transducer and a floating transducer, said series of groups allowing the energy conversion efficiency between the inputs and outputs to be enhanced.

8. The power device according to claim 7 insofar as it refers to a combiner according to claim 1, **characterised in that** in a same nth acoustic channel, the input transducer of a group Gᵢⱼ of an nth acoustic channel is separated from the input transducer of the group G_{i,(j+1)} by a distance such that an acoustic wave propagating from the group Gᵢⱼ to the group G_{i,(i+1}) undergoes a phase shift of 2kπ, with k being an integer, between the two input transducers.

9. The power device according to claim 7 insofar as it refers to a splitter according to claim 2, **characterised in that** in a same nth acoustic channel, the output transducer of a group Gᵢⱼ of an nth acoustic channel is separated from the output transducer of the group G_{i,(j+1)} by a distance such that an acoustic wave propagating from the group Gᵢⱼ to the group G_{i,(i+1)} undergoes a phase shift of 2kπ, with k being an integer, between the two output transducers.

10. The power device according to any one of claims 1 to 9, **characterised in that** each acoustic channel comprises acoustic reflectors at each of its ends.

11. The power device according to claim 10, **characterised in that** said reflectors are arrays of short-circuited interdigitated combs.
